**Europäisches Patentamt**

**European Patent Office**

**Office européen des brevets**

(19)

(11) Veröffentlichungsnummer : **0 460 274 B1**

(12)

# EUROPÄISCHE PATENTSCHRIFT

(45) Veröffentlichungstag der Patentschrift :
**31.05.95 Patentblatt 95/22**

(51) Int. Cl.$^6$ : **H03L 7/081**

(21) Anmeldenummer : **90110897.7**

(22) Anmeldetag : **08.06.90**

(54) **Verfahren und Schaltungsanordnung für einen Phasenkomparator.**

(43) Veröffentlichungstag der Anmeldung :
**11.12.91 Patentblatt 91/50**

(45) Bekanntmachung des Hinweises auf die
Patenterteilung :
**31.05.95 Patentblatt 95/22**

(84) Benannte Vertragsstaaten :
**AT BE CH DE FR GB IT LI NL SE**

(56) Entgegenhaltungen :
**EP-A- 0 353 807**
**FR-A- 2 604 836**

(73) Patentinhaber : **SIEMENS
AKTIENGESELLSCHAFT
Wittelsbacherplatz 2
D-80333 München (DE)**

(72) Erfinder : **König, Wilhelm, Dipl.-Ing.
Frickingerstrasse 8
D-8900 Augsburg (DE)**
Erfinder : **Müller, Rudi, Dr. Dipl.-Phys.
Von-Branca-Strasse 35
D-8038 Gröbenzell (DE)**

**Beschreibung**

Die Erfindung betrifft ein Verfahren und eine dieses Verfahren realisierende Schaltungsanordnung zur Einregelung einer mit einer Mehrzahl von spannungsgesteuerten Verzögerungselementen gebildeten Verzögerungsleitung, die zusammen mit einem Phasendetektor und einem Tiefpaßfilter einen Phasenregelkreis bildet, auf genau eine Periode eines eigangsseitig zugeführten Taktsignals, wobei die Phasenlage des dem ersten spannungsgesteuerten Verzögerungselementes und die Phasenlage des Ausgangssignals des letzten Verzögerungselementes ausgewertet wird und aus der Auswertung eine Steuerspannung zur Steuerung der Verzögerungsdauer der spannungsgesteuerten Verzögerungselemente abgeleitet wird. Bei Datenverarbeitungssystemen mit hohen Bitraten tritt das Problem auf, daß die Phasenbeziehungen zwischen Takt und Daten in hohem Maße von der Länge der Verbindungsleitungen auf und zwischen den Baugruppen beeinflußt wird. Eine Taktverteilung, die genau definierte Phasen zwischen Takt und Daten an den Eingängen von Bausteinen sicherstellt, erfordert einen hohen Aufwand bei der Aufbautechnik. Denkbar wäre beispielsweise auch eine zusätzliche Codierung der Daten und eine lokale Taktrückgewinnung, wobei solche Maßnahmen jedoch ebenfalls erheblichen Aufwand bedeuten würden. Zur Lösung des genannten Problems sind in den Bausteinen üblicherweise Phasenanpaßschaltungen vorgesehen, die eine korrekte Abtaktung der dem jeweiligen Baustein über die Eingänge zugeführten Daten, unabhängig von der Phasenbeziehung zwischen dem Takt und den Daten sicherstellen. Unter Abtaktung soll dabei die Ermittlung des logischen Zustandes eines Datenbits verstanden werden, die vorteilhafterweise in der Mitte einer Bitzeitdauer erfolgt. In diesen Phasenanpaßschaltungen werden in der Regel eine Mehrzahl von Taktsignalen benötigt, die jeweils zum vorhergehenden Taktsignal um einen festen Betrag verzögert sind. Zur Erzeugung dieser Taktsignale kommen üblicherweise Verzögerungsleitungen zum Einsatz, die mit einer Mehrzahl von Verzögerungselementen gebildet sind. Diese Verzögerungselemente können durch Inverterstufen gegeben sein, wobei deren Gatterlaufzeit zur Verzögerung eines Digitalsignals ausgenutzt wird. Dabei macht es sich nachteilig bemerkbar, daß die Verzögerungszeiten von mit Inverterstufen gebildeten Verzögerungselementen in nicht zu vernachlässigendem Maße sowohl von Technologieschwankungen bei der Herstellung, als auch von sich ändernden Betriebsparametern wie Temperatur und Versorgungsspannung abhängig sind. Zur Erzielung von definierten Verzögerungszeiten wird üblicherweise eine Spannungssteuerung der Verzögerungselemente mit Hilfe eines Phasenregelkreises vorgenommen.

Kommt in einem solchen Phasenregelkreis ein reiner Phasenvergleicher zum Einsatz, so macht es sich nachteilig bemerkbar, daß ein solcher Phasenvergleicher auch auf harmonische Frequenzen verriegelt und sich damit in der Verzögerungsleitung Vielfache des vorgesehenen Taktsignals befinden.

Aus der EP-0 353 807 ist eine mit acht spannungsgesteuerten Verzögerungselementen gebildete Verzögerungsleitung bekannt, die zusammen mit einem Phasendetektor und einer Anzahl von Tiefpaßfiltern einen Phasenregelkreis bildet und deren Verzögerungsdauer im regulären Betrieb auf eine Periode eines eingangsseitig zugeführten Taktsignals eingeregelt wird. Zur Einregelung der Verzögerungsdauer werden dabei die Ausgangssignale des ersten, des zweiten, des dritten und des achten Verzögerungselementes zwei Auswerteschaltungen zugeführt, die jeweils mit einem mit einem Widerstand und einem Kondensator gebildeten Tiefpaßfilter verbunden sind; ein Differenzverstärker, dessen beide Eingänge mit den Tiefpaßfiltern verbunden sind, gibt ausgangsseitig eine kontinuierliche Steuerspannung zur Steuerung der Betriebsspannung der spannungsgesteuerten Verzögerungselemente ab. Hinweise auf die Problematik und die Vermeidung der Ausbildung einer Mehrzahl von Perioden des Taktsignals innerhalb der Verzögerungsleitung sind aus diesem Dokument nicht ersichtlich.

Aus der DE-OS 37 33 554 ist eine durch einen Phasenregelkreis geregelte Verzögerungsschaltung bekannt, deren Verzögerungsleitung mit spannungsgesteuerten Verzögerungselementen gebildet ist, und deren ersten Verzögerungselement ein Taktsignal zugeführt wird und bei der das Steuersignal für die spannungsgesteuerten Verzögerungselemente von einem Phasendetektor mit nachgeschaltetem Tiefpaßfilter ermittelt wird, wobei der Phasendetektor die Phasenlage des dem ersten Verzögerungselement zugeführten Taktsignals mit dem von dem letzten Verzögerungselement abgegebenen Taktsignal vergleicht. Um zu vermeiden, daß sich harmonische Frequenzen des vorgesehenen Taktsignals in der Verzögerungsleitung ausbilden, wird die Verzögerungszeit dieser Schaltungsanordnung bei Anlegen der Versorgungsspannung aus dem Grundzustand, in dem die Verzögerungselemente auf die kürzest mögliche Verzögerungszeit eingestellt sind, solange stufenweise erhöht, bis der Phasendetektor auf eine einzige Periode des Taktsignals verriegelt. In dieser Schaltungsanordnung ist zur Erkennung von durch fehlerhaften Betrieb in der Verzögerungsleitung auftretender Vielzahliger des Taktsignals eine Einrichtung zur Überwachung der Signalform des sich in der Verzögerungsleitung zu einem bestimmten Zeitpunkt befindlichen Taktsignals vorgesehen, die die Signalform des sich in der Verzögerungsleitung befindlichen Taktsignals zwischen zwei signifikanten Signalübergängen des Taktsignals, beispielsweise in der Impulspause, auf die vorgesehene Signalpegellage hin überprüft, indem sie die Ausgangssignale einer Mehrzahl von benachbarten Verzögerungselementen auswertet. Dabei macht es sich nachteilig bemerkbar, daß das Ansprechen der Überwachungseinrichtung ein Zurücksetzen der Schaltungsanordnung in den Grundzustand bewirkt, aus dem heraus die Verzögerungszeit stufenweise auf eine volle Taktperiode erhöht wird, wobei ein dort vorgesehener Dreiphasenvergleich das Einschwingen des Phasenregelkreises zusätzlich verlangsamt.

Die Erfindung stellt sich nun die Aufgabe, einen Phasendetektor anzugeben, der in einem Verzögerungsbereich der auch Vielfache der vorgesehenen Verzögerungsdauer umfaßt, stets eine proportionale Stellgröße abzugeben vermag.

Die Aufgabe wird durch einen gattungsgemäßen Gegenstand gelöst, bei dem eine kontinuierliche Steuerspannung unter zusätzlicher Auswertung des Ausgangssignals des zweiten, des dritten und des fünften Verzögerungselementes einer insgesamt acht Verzögerungselemente aufweisenden Verzögerungsleitung erzeugt wird.

Die Erfindung bringt den Vorteil mit sich, daß in einem Verzögerungsbereich bis zum Vierfachen der vorgesehenen Verzögerungsdauer eine stetige Steuerspannung für eine kontinuierliche Phasenregelung gegeben ist, ohne daß bei Auftreten eines Betriebszustandes, in dem sich Vielfache der vorgesehenen Taktperiode in dem Verzögerungselement ausbilden, in den Grundzustand, in dem die Verzögerungselemente auf eine kürzestmögliche Verzögerungsdauer eingestellt sind, gegangen wird und von dem aus die Verzögerungsdauer an die vorgesehene Verzögerungsdauer herangeführt werden muß. Darüber hinaus ist der erfindungsgemäße Gegenstand unempfindlich gegenüber Schwankungen im Tastverhältnis des zugeführten Taktsignals, die bis zu einem Zehntel der Periode des Taktsignals von dem Tastverhältnis abweichen, das der Hälfte der Periode des Taktsignals entspricht.

In weiterer Ausgestaltung der Erfindung weist das Tiefpaßfilter zwei Ladungspumpen auf, die einen Kondensator zu speisen vermögen, wobei die erste Ladungspumpe eingangsseitig über eine Auswerteschaltung des Phasendetektors mit den Ausgängen des zweiten, des dritten und des fünften Verzögerungselementes verbunden ist, während die zweite Ladungspumpe eingangsseitig mit dem Ausgang des achten Verzögerungselementes verbunden ist. Diese Maßnahme bringt den Vorteil mit sich, daß in dem benachbarten Verzögerungsbereich, der an den Verzögerungsbereich angrenzt, in dem alleine die zweite Ladungspumpe die Steuerspannung beeinflußt, sich die Ströme der ersten Ladungspumpe und der zweiten Ladungspumpe gleichsinnig überlagern und sich somit aus diesen benachbarten Bereichen heraus ein Einschwingen auf die vorgesehene Verzögerungszeit mit einer verkleinerten Regelzeitkonstante ergibt.

Die Erfindung wird nun anhand von Figuren im zum Verständnis der Erfindung erforderlichen Umfang beispielsweise beschrieben.

Dabei zeigen

FIG 1 ein Blockschaltbild einer gattungsgemäßen Schaltungsanordnung,

FIG 2 ein Blockschaltbild des erfindungsgemäßen Phasenvergleichers mit nachgeschaltetem Tiefpaßfilter,

FIG 3 ein Schaltbild des erfindungsgemäßen Phasenvergleichers mit nachgeschaltetem Tiefpaßfilter, das nähere Einzelheiten erkennen läßt,

FIG 4 Signalzustände in der erfindungsgemäßen Schaltungsanordnung und

FIG 5 eine Darstellung der Überlagerung der Ladeströme der Ladungspumpen CP1 und CP2.

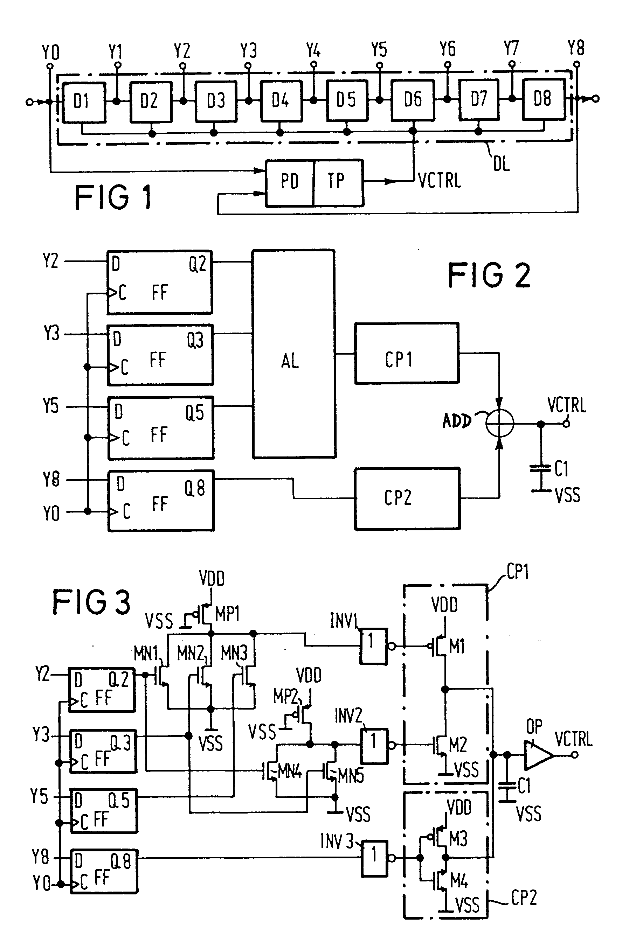

FIG 1 zeigt eine an sich bekannte Schaltungsanordnung zur Erzeugung einer Mehrzahl von um einen festen Betrag gegeneinander phasenverschobener Taktsignale. Eine Verzögerungsleitung DL ist mit einer Mehrzahl von beispielsweise 8 untereinander gleicher Verzögerungselemente D1...D8 gebildet, die in Kette geschaltet sind. Dem Eingang des Verzögerungselements D1 wird am Eingang Y0 ein Taktsignal zugeführt, das am Ausgang Y1 des Verzögerungselementes D1 entsprechend verzögert abgegriffen werden kann. In gleicher Weise liefern die mit dem Verzögerungselement D1 in Kette geschalteten Verzögerungselemente D2...D8 an ihren jeweiligen Ausgängen Y2...Y8 ein Signal, das gegenüber dem Eingangssignal Y0 entsprechend der Anzahl der durchlaufenen Verzögerungselemente verzögert ist.

In dem Ausführungsbeispiel ist vorgesehen, daß das Taktsignal am Ausgang Y8 der Verzögerungsleitung DL gegenüber dem Taktsignal am Eingang Y0 der Verzögerungsleitung DL um eine Taktperiode verzögert ist.

Das dem Eingang Y0 der Verzögerungsleitung DL zugeführte Taktsignal und das am Ausgang Y8 der Verzögerungsleitung abgegebene Taktsignal werden jeweils einem Eingang eines Phasendetektors PD zugeführt. In dem Phasendetektor PD wird der Phasenunterschied zwischen den an den beiden Eingängen anliegenden Signalen ermittelt und in ein Korrektursignal umgesetzt, das in einem Tiefpaß TP geglättet wird und als Steuerspannung VCTRL den spannungsgesteuerten Verzögerungselementen D1...D8 zugeführt wird.

Die spannungsgesteuerten Verzögerungselemente D1...D8 können in prinzipiell bekannter Weise (IEEE Journal of Solid-State-Circuits , Vol. 23 No. 5, Oktober 1988 Seite 1218... 1223, Figur 3 a, b) gebildet sein. Demnach ist ein jeweiliges Verzögerungselement mit einem CMOS-Inverter gebildet, dessen Betriebsspannungsanschlüsse über einen mit Hilfe einer Steuerspannung VCTRL steuerbaren Stromspiegel mit den Anschlüssen der Betriebsspannungsquelle verbunden sind. Bei einem solchen Verzögerungselement wird die Verzögerungszeit durch den Konstantstrom bestimmt, den der Stromspiegel zum Umladen der inverterausgangsseitigen (parasitären) Lastkapazität zuläßt. Ein anderes, in der genannten Schrift in prinzipieller Weise dargestelltes Verzögerungselement ist dadurch gegeben, daß am Ausgang eines CMOS-Inverters eine Kapazität über einen steuerbaren Widerstand mit dem niedrigen Potential der Betriebsspannungsquelle verbunden ist. Der steuerbare Widerstand ist dabei mit einem Feldeffekttransistor gebildet, dem an der Steuerelektrode die Steuerspannung VCTRL zugeführt wird, während der Kondensator durch einen (großflächigen) Feldeffekttransistor gegeben sein kann, dessen Steuerelektrode mit dem steuerbaren Widerstand und dessen Hauptelektroden mit dem niedrigen Potential der Betriebsspannungsquelle verbunden sind.

In dem erfindungsgemäßen Ausführungsbeispiel wird von einem nichtinvertierenden Verhalten der Verzögerungselemente ausgegangen, wodurch bei den beschriebenen Verzögerungselementen jeweils ein nachgeschalteter Inverter erforderlich wird, der wiederum durch einen CMOS-Inverter gegeben sein kann.

In dem erfindungsgemäßen Ausführungsbeispiel werden nun die Ausgangssignale Y2, Y3, Y5 und Y8 der Verzögerungselemente D2, D3, D5 und D8, denen Verzögerungszeiten von 2/8, 3/8, 5/8 und 8/8 der gesamten Verzögerungszeit der Verzögerungsleitung zukommen, zu einem festen Zeitpunkt periodisch abgefragt und ausgewertet. Die Abfrage dieser Ausgangssignale erfolgt dabei in jeder Periode mit der führenden Flanke des dem Verzögerungselement D1 am Eingang Y0 zugeführten Taktsignals, wobei im Ausführungsbeispiel von der steigenden Flanke des Taktsignals als führender Flanke ausgegangen wird. Bei einer vorgesehenen Verzögerung td des Taktsignals in der Verzögerungsleitung DL um eine Periode T erscheinen dann an den Ausgängen Y2, Y3, Y5 und Y8 Ausgangssignale, die entsprechend folgender Tabelle ausgewertet werden können.

TABELLE

| Verzögerung td | Y2 | Y3 | Y5 | Y8 |
|---|---|---|---|---|
| $0 < td < 4T/5$ | 0 | 0 | 0 | x |
| $4T/5 < td < 4T/3$ | 0 | 0 | 1 | 0 oder 1 |
| $4T/3 < td < 4T$ | nicht (0 | 0) | x | x |

(x = unbeachtlich)

Für eine Verzögerung td des Taktsignals in einem Bereich, der zwischen 4T/5 und 4T/3 liegt, in dem auch die vorgesehene Verzögerung td des Taktsignals um eine Periode T fällt, erscheint an den Ausgängen Y2 und Y3 jeweils ein LOW-Signal, während am Ausgang Y5 ein HIGH-Signal erscheint, wohingegen das Signal am Ausgang Y8 entweder den High- oder den Low-Zustand annehmen kann, wobei bei Vorliegen eines Low-Signals die Verzögerungsdauer verkürzt werden muß, während bei Vorliegen eines High-Signals die Verzögerungsdauer verlängert werden muß.

Für eine Verzögerung td des Taktsignals in einem Bereich, der zwischen 0T und 4T/5 liegt, erscheint an den Ausgängen Y2, Y3 und Y5 jeweils ein Low-Signal, während das Signal am Ausgang Y8 unbeachtlich bleibt, wobei bei Vorliegen dieser Ausgangssignalkombination die Verzögerungsdauer verlängert werden muß.

Der Verzögerungsbereich zwischen 4T/3 und 4T ist dadurch bestimmt, daß weder der Ausgang Y2 noch der Ausgang Y3 ein Low-Signal führen, wobei Ausgangssignale des Ausgangs Y5 und Y8 unbeachtlich bleiben. Das Vorliegen der letztgnannten Ausgangszustände wird dahingehend ausgewertet, daß die Verzögerungsdauer verkürzt wird.

In FIG 2 ist ein Blockschaltbild einer Schaltungsanordnung dargestellt, die die Auswertung entsprechend obiger Tabelle realisiert. Die Ausgangssignale Y2, Y3, Y5 und Y8 werden jeweils dem D-Eingang eines D-Flip-Flop zugeführt, und mit der steigenden Flanke des Taktsignals , das gleichzeitig das Eingangssignal des Verzögerungselements D1 bildet, und das dem Clock-Eingang C der Flip-Flops zugeführt wird, in das jeweilige Flip-Flop übernommen. Das Ausgangssignal des Ausgangs Q8 des Flip-Flops, das das Ausgangssignal Y8 übernommen hat, wird einer Ladungspumpe CP2 zugeführt, die abhängig von diesem Ausgangssignal über eine Überlagerungseinrichtung ADD einem Kondensator C1 Ladung zuführt oder entnimmt, und dadurch die Steuerspannung VCTRL am Kondensator C1 entsprechend zu ändern vermag. Die Ausgangssignale an den Ausgängen Q2, Q3 und Q5 der zugehörigen Flip-Flops FF werden entsprechend obiger Tabelle in einer Auswertelogik AL miteinander logisch verknüpft. Das Ausgangssignal der Auswertelogik AL wird einer Ladungspumpe CP1 zugeführt, die in Abhängigkeit von diesem Ausgangssignal über die Überlagerungseinrichtung ADD die Steuerspannung VCTRL am Kondensator C1 in gleicher Weise wie die Ladungspumpe CP1 zu ändern vermag.

In FIG 3 werden nähere Einzelheiten einer vorteilhaften Ausgestaltung der erfindungsgemäßen Schaltungsanordnung verdeutlicht. Die Flip-Flops FF stellen, wie für FIG 2 beschrieben, an ihren Ausgängen Q entsprechende Signale bereit. Das Signal am Ausgang Q8 gelangt über einen Inverter INV3 an den Steuereingang der mit einem CMOS-Inverter gebildeten Ladungspumpe CP2. Dieser CMOS-Inverter ist mit der Serienschaltung von einem P-Kanal-Transistor M3 mit einem N-Kanal-Transistor M4 gebidet, wobei die der Serienschaltung abgewandte Hauptelektrode des Transistors M3 mit dem hohen Potential VDD der Versorgungsspannung verbunden ist und die der Serienschaltung abgewandte Hauptelektrode des Transistors M4 mit dem niedrigen Potential VSS der Versorgungsspannung verbunden ist und die Steuerelektroden dieser Transistoren den Steuereingang des CMOS-Inverters bilden. Die Verbindung der Hauptelektroden dieser Transistoren M3, M4 bildet den Ausgang der Ladungspumpe CP2 und ist mit dem Kondensator C1 verbunden.

Die Ausgangssignale Q2, Q3 und Q5 der zugehörigen Flip-Flops FF werden jeweils einem Eingang einer mit den Transistoren MN1, MN2, MN3 und MP1 gebildeten, die logische NOR-Funktion realisierenden Transistorschaltung zugeführt. Diese Transistorschaltung ist durch die Serienschaltung von dem P-Kanal-Transistor MP1 mit der Parallelschaltung der N-Kanal-Transistoren MN1, MN2 und MN3 gegeben. Der Transistor MP1 ist mit seiner der Serienschaltung abgewandten Hauptelektrode mit dem hohen Potential VDD der Versorgungsspannung und mit seiner Steuerelektrode mit dem niedrigen Potential VSS der Versorgungsspannung verbunden, wodurch er für die Transistoren MN1, MN2, MN3 wie ein Arbeitswiderstand wirkt. Die Transistoren MN1, MN2, MN3 sind mit ihrer der Serienschaltung abgewandten Hauptelektrode mit dem niedrigen Potential VSS der Versorgungsspannung verbunden und mit ihrer Steuerelektrode jeweils mit einem Flip-Flop-Ausgang Q2, Q3, Q5 verbunden. Die der Serienschaltung zugewandten Hauptelektroden der Transistoren MP1, MN1, MN2, MN3 bilden den Ausgang dieser Transistorschaltung, der über einen Inverter INV1 mit der Steuerelektrode eines P-Kanal-Transistors M1 verbunden ist.

Die Ausgangssignale Q2 und Q3 der entsprechenden Flip-Flops FF werden zusätzlich jeweils einem Eingang einer weiteren mit den Transistoren MP2, MN4, MN5 gebildeten, die logische NOR-Funktion realisierenden Transistorschaltung zugeführt. Diese Transistorschaltung ist in gleicher Weise aufgebaut wie die weiter oben beschriebene, so daß sich eine weitere Beschreibung erübrigt. Der P-Kanal-Transistor MP2 wirkt wiederum als Arbeitswiderstand für die parallelgeschalteten N-Kanal-Transistoren MN4, MN5, denen an ihrer Steuerelektrode jeweils ein Ausgangssignal Q2 bzw. Q3 zugeführt wird. Der Ausgang dieser Transistorschaltung ist über einen Inverter INV2 mit dem Steuereingang eines N-Kanal-Transistors M2 verbunden. Die Serienschaltung der Transistoren M1 und M2 bildet die Ladungspumpe CP1, wobei die der Serienschaltung abgewandte Hauptelektrode des Transistors M1 mit dem hohen Potential VDD der Versorgungsspannung und die der Serienschaltung abgewandte Hauptelektrode des Transistors M2 mit dem niedrigen Potential VSS der Versorgungsspannung verbunden ist. Die Verbindung der der Serienschaltung zugewandten Hauptelektrode der Transistoren M1 und M2 ist mit dem Kondensator C1 verbunden. Die Steuerspannung VCTRL an dem Kondensator C1 wird über einen Operationsverstärker OP gepuffert, wobei bedarfsweise eine Invertierung vorgenommen werden kann. Die Ladungspumpen CP1 und CP2 bilden zusammen mit dem Kondensator C1 den Tiefpaßfilter TP. Der Kondensator C1 kann außerhalb eines integrierten Bausteins, auf dem die Schaltungsanordnung nach FIG 3 realisiert ist, angeordnet sein oder auf dem integrierten Baustein realisiert werden, wobei der Kondensator C1 dann in bekannter Weise (aus IEEE Journal of Solid-State Circuits, Vol. 23, No. 5, October 1988 S. 1221, FIG 8) mit einem großflächigen N-Kanal-Transistor gebildet sein kann, der mit seiner Steuerelektrode mit den Ausgängen der Ladungspumpen CP1 und CP2 verbunden ist und der mit seinen Hauptelektroden mit dem niedrigen Potential VSS der Versorgungsspannung verbunden ist.

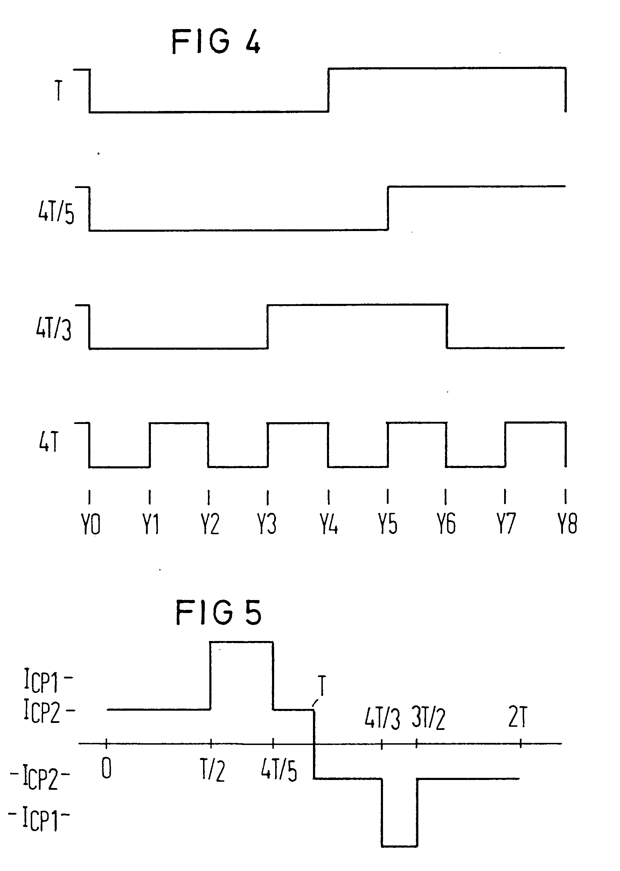

Liegt nun die Verzögerung td in einem Bereich zwischen 4T/5 und 4T/3, in dem auch die vorgesehene Verzögerung von T fällt (vergleiche Tabelle zweite Zeile und FIG 4, Zeile T), so stehen an den Ausgängen Q2, Q3, Q5 der zugehörigen Flip-Flops FF die Wertekombination 0,0,1 an. Bei dieser Wertekombination gibt die mit den Transistoren MP1, MN1, MN2, MN3 gebildete Transistorschaltung am Ausgang ein LOW-Signal, das in dem nachgeschalteten Inverter INV1 in ein HIGH-Signal invertiert wird, an die Steuerelektrode des Transistors M1 ab, der dadurch gesperrt ist; bei dieser Wertekombination gibt die mit den Transistoren MP2, MN4, MN5 gebildete Transistorschaltung an ihrem Ausgang ein HIGH-Signal, das in dem nachgeschalteten Inverter INV2 in ein LOW-Signal invertiert wird, an die Steuerelektrode des Transistors M2 ab, der dadurch ebenfalls gesperrt ist. Bei dieser Wertekombination weist die Ladungspumpe CP1 am Ausgang einen hochohmigen Zustand auf und nimmt damit keinen Einfluß auf die Steuerspannung VCTRL.

Bei dieser Wertekombination bestimmt also die Ladungspumpe CP2 in Abhängigkeit von dem über den Ausgang Q8 des zugehörigen Flip-Flops FF und den Inverter INV3 zugeführten Steuersignal die Steuerspannung VCTRL.

Ist die Verzögerung td kürzer als 4T/5 (vergl. Tabelle Zeile 1 und FIG 4, Zeile 4T/5), so stehen an den Ausgängen Q2, Q3, Q5 der zugehörigen Flip-Flops FF jeweils ein LOW-Signal an, so daß der Transistor M2 gesperrt ist und der Transistor M1 leitend geschaltet ist, wodurch die Spannung am Kondensator C1 erhöht wird.

Liegt die Verzögerung td der Verzögerungsleitung DL in einem Bereich von 4T/3 und 4T (vergl. Tabelle dritte Zeile und FIG 4 Zeilen 4T/3,4 T), so weist mindestens einer der Ausgänge Q2, Q3 der zugehörigen Flip-Flops FF ein HIGH-Signal auf, so daß der Transistor M1 sperrt und der Transistor M2 leitend geschaltet ist, wodurch die Spannung an dem Kondensator C1 verringert wird.

Die Ladungspumpe CP1 beeinflußt die Spannung am Kondensator C1 nur, wenn die Verzögerung td der Verzögerungsleitung DL außerhalb des Bereichs 4T/5 und 4/3 liegt, wobei sich der Ausgangsstrom der Ladungspumpe CP1 mit dem Ausgangsstrom der Ladungspumpe CP2 überlagert.

Damit über den gesamten Arbeitsbereich von 0T bis 4T der Schaltungsanordnung die Änderung der Spannung am Kondensator C1 in die erforderliche Richtung erfolgt, muß das Ausgangssignal der Ladungspumpe CP1 dominant gegenüber dem Ausgangssignal der Ladungspumpe CP2 sein. Dies kann dadurch erreicht werden, daß die Ladungspumpe CP1 einen höheren Konstantstrom zu liefern vermag als die Ladungspumpe CP2. Eine höhere Stromergiebigkeit der Ladungspumpe CP1 gegenüber der Ladungspumpe CP2 läßt sich beispielsweise dadurch erzielen, daß die Transistoren M1, M2 der Ladungspumpe CP1 größer dimensioniert werden als die entsprechenden Transistoren M3, M4 der Ladungspumpe CP2. Bei dem erfindungsgemäßen Ausführungsbeispiel nach FIG 3 überlagern sich die Ausgangsströme der Ladungspumpen CP1, CP2 in den Bereichen zwischen T/2 und 4T/5 sowie zwischen 4T/3 und 3T/2, die sich unmittelbar an den Bereich anschließen, der zwischen 4T/5 und 4T/3 liegt und in dem alleine die Ladungspumpe CP2 die Spannung am Kondensator C1 beeinflußt, gleichsinnig, so daß für Verzögerungen, die in diesen anschließenden Bereichen liegen, ein beschleunigtes Einschwingen des Phasenregelkreises resultiert.

In FIG 4 ist für unterschiedliche Verzögerungsdauern td eine räumliche Darstellung gegeben, wieweit ein Taktsignal mit einem Tastverhältnis von 0,5 bei Eintreffen der steigenden Flanke am Eingang Y0 der Verzögerungsleitung DL innerhalb der Verzögerungsleitung DL fortgeschritten ist. Dabei zeigt Zeile T ein Taktsignal, das genau um die vorgesehene Verzögerungsdauer von T verzögert ist. Die Zeilen T/5, 4T/3 und 4T zeigen Signale, die entsprechend verzögert sind. In FIG 4 unten sind die Anschlüsse Y0...Y8 der Verzögerungsleitung DL den dargestellten Signalen räumlich zugeordnet, wobei diesen Anschlüssen bei Eintreffen einer steigenden Flanke am Eingang Y0 der Verzögerungsleitung DL entsprechende Ausgangssignale entnommen werden können.

In FIG 5 ist für Verzögerungen td in einem Bereich von 0T bis 2T der erfindungsgemäßen Schaltungsanordnung nach FIG 2 und FIG 3 dargestellt, welche Ladeströme sich für den Kondensator C1 ergeben unter der Annahme, daß die Ladeströme $I_{CP1}$,-$I_{CP1}$ der Ladungspumpe CP1 doppelt so groß sind wie die Ladeströme $I_{CP2}$,-$I_{CP2}$ der Ladungspumpe CP2. In dem Bereich von 0T bis T/2 und in dem Bereich von 4T/5 bis 4T/3 alleine die Ladungspumpe CP2 den Ladestrom für den Kondensator C1, wobei der Ladestrom bei T seine Richtung wechselt. In dem Bereich von T/2 bis 4T/5 und 4T/3 bis 3T/2 überlagern sich die von den Ladungspumpen CP1 und CP2 jeweils abgegebenen Ladeströme gleichsinnig. In dem Bereich zwischen 3T/2 und 2T ergibt sich der resultierende Ladestrom aus der Differenz der Ladeströme -$I_{CP1}$ und $I_{CP2}$. Bezüglich des Tastverhältnisses des Taktsignals sei noch darauf hingewiesen, daß der im Ausführungsbeispiel beschriebene Phasendetektor PD unempfindlich ist gegen Schwankungen im Tastverhältnis, die kleiner sind als sie einem Zehntel einer Taktperiode T entsprechen.

Weiter sei noch darauf hingewiesen, daß der Arbeitsbereich des Phasendetektors von 0T bis 4T, innerhalb dessen er stets eine entsprechende Steuerspannung VCTRL abzugeben vermag, ausreicht, um Streuungen der Verzögerungsdauer td, die sich durch Kumulation von ungünstigen Parametern wie beispielsweise aus dem Herstellungsprozeß, der Betriebsspannung oder der Betriebstemperatur ergeben können, auszuregeln.

## Patentansprüche

1.    Verfahren zur Einregelung einer mit einer Mehrzahl von spannungsgesteuerten Verzögerungselementen (D1..D8) gebildeten Verzögerungsleitung (DL), die zusammen mit einem Phasendetektor (PD) und einem Tiefpaßfilter (TP) einen Phasenregelkreis bildet, auf genau eine Periode eines eingangsseitig zugeführten Taktsignals, wobei die Phasenlage des dem ersten spannungsgesteuerten Verzögerungselementes (D1) und die Phasenlage des Ausgangssignals des letzten Verzögerungselementes (D8) ausgewertet wird und aus der Auswertung eine Steuerspannung (VCTRL) zur Steuerung der Verzögerungsdauer der spannungsgesteuerten Verzögerungselemente abgeleitet wird,
**dadurch gekennzeichnet**, daß
eine kontinuierliche Steuerspannung unter zusätzlicher Auswertung des Ausgangssignals des zweiten, des dritten und des fünften Verzögerungselementes einer insgesamt acht Verzögerungselemente aufweisenden Verzögerungsleitung erzeugt wird.

**2.** Schaltungsanordnung zur Einregelung einer mit einer Mehrzahl von spannungsgesteuerten Verzögerungselementen (D1..D8) gebildeten Verzögerungsleitung (DL), die zusammen mit einem Phasendetektor (PD) und einem Tiefpaßfilter (TP) gebildet ist, auf genau eine Periode eines eingangsseitig zugeführten Taktsignals, wobei der Eingang (YO) des ersten spannungsgesteuerten Verzögerungselementes (D1) und der Ausgang (Y8) des letzten spannungsgesteuerten Verzögerungselementes (D8) mit zwei Eingängen des Phasendetektors verbunden sind und die Betriebsspannungsanschlüsse der spannungsgesteuerten Verzögerungselemente mit dem Ausgang des Tiefpaßfilters verbunden sind,
**dadurch gekennzeichnet,** daß
die Verzögerungsleitung acht Verzögerungselemente (D1..D8) aufweist und der Ausgang des zweiten Verzögerungselementes, der Ausgang des dritten Verzögerungselementes und der Ausgang des fünften Verzögerungselementes mit weiteren Eingängen des Phasendetektors verbunden sind.

**3.** Schaltungsanordnung nach Anspruch 2,
**dadurch gekennzeichnet,** daß
das Tiefpaßfilter (TP) eine erste und eine zweite Ladungspumpe (CP1, CP2) aufweist, die einen Kondensator (C1) zu speisen vermögen, wobei die erste Ladungspumpe (CP1) eingangsseitig über eine Auswerteschaltung (AL) des Phasendetektors (PD) mit dem Ausgang (Y2) des zweiten Verzögerungselementes (D2), dem Ausgang (Y3) des dritten Verzögegerungselementes (D3) und dem Ausgang (Y5) des fünften Verzögerungselementes (D5) verbunden ist, während die zweite Ladungspumpe (CP2) eingangsseitig mit dem Ausgang (Y8) des achten Verzögerungselementes (D8) verbunden ist.

**4.** Schaltungsanordnung nach Anspruch 3,
**dadurch gekennzeichnet,** daß
die erste Ladungspumpe (CP1) gegenüber der zweiten Ladungspumpe (CP2) einen größeren Strom zu führen vermag.

## Claims

**1.** Method for adjusting a delay line (DL) formed by means of a plurality of voltage-controlled delay elements (D1..D8) which, together with a phase detector (PD) and a low-pass filter (TP), forms a phase-locked loop, to exactly one period of a clock signal supplied at the input end, the phase angle of the first voltage-controlled delay element (D1) and the phase angle of the output signal of the last delay element (D8) being evaluated and a control voltage (VCTRL) for controlling the duration of the delay of the voltage-controlled delay elements being derived from the evaluation, characterized in that a continuous control voltage is generated with additional evaluation of the output signal of the second, the third and the fifth delay element of a delay line exhibiting a total of eight delay elements.

**2.** Circuit arrangement for adjusting a delay line (DL) formed by means of a plurality of voltage-controlled delay elements (D1..D8), which is formed together with a phase detector (PD) and a low-pass filter (TP), to exactly one period of a clock signal supplied at the input end, the input (YO) of the first voltage-controlled delay element (D1) and the output (Y8) of the last voltage-controlled delay element (D8) being connected to two inputs of the phase detector and the operating voltage connections of the voltage-controlled delay elements being connected to the output of the low-pass filter, characterized in that the delay line exhibits eight delay elements (D1..D8) and the output of the second delay element, the output of the third delay element and the output of the fifth delay element are connected to further inputs of the phase detector.

**3.** Circuit arrangement according to Claim 2, characterized in that the low-pass filter (TP) exhibits a first and a second charge pump (CP1, CP2) which are capable of feeding a capacitor (C1), the input of the first charge pump (CP1) being connected to the output (Y2) of the second delay element (D2), the output (Y3) of the third delay element (D3) and the output (Y5) of the fifth delay element (D5) via an evaluating circuit (AL) of the phase detector (PD) whilst the input of the second charge pump (CP2) is connected to the output (Y8) of the eighth delay element (D8).

**4.** Circuit arrangement according to Claim 3, characterized in that the first charge pump (CP1) is capable of carrying a higher current compared with the current of the second charge pump (CP2).

**Revendications**

1.  Procédé de réglage d'une ligne à retard (DL), qui est constituée d'une multiplicité d'éléments à retard (D1 .. D8) commandés en tension et qui forme une boucle à verrouillage de phase conjointement avec un détecteur de phase (PD) et un filtre passe-bas (TP), sur exactement une période d'un signal de cadence qui est amené côté entrée, selon lequel on évalue la relation de phase du premier élément à retard (D1) commandé en tension et la relation de phase du signal de sortie du dernier élément de retard (D8) et on déduit de l'évaluation une tension de commande (VCTRL) pour la commande de la durée de retard des éléments à retard commandés en tension,

    caractérisé par le fait que l'on produit une tension continue de commande, en évaluant en plus le signal de sortie des deuxième, troisième et cinquième éléments à retard d'une ligne à retard qui comporte en tout huit éléments à retard.

2.  Montage de réglage d'une ligne à retard (DL), qui est constituée d'une multiplicité d'éléments à retard (D1 .. D8) commandés en tension et qui est formée en même temps d'un comparateur de phase (PD) et d'un filtre passe-bas (TP), sur exactement une période d'un signal de cadence qui est amené côté entrée, l'entrée (YO) du premier élément à retard (D1) commandé en tension et la sortie (Y8) du dernier élément à retard (D8) commandé en tension étant reliées à deux entrées du détecteur de phase et les bornes de tension de fonctionnement des éléments à retard commandés en tension sont reliées à la sortie du filtre passe-bas,

    caractérisé par le fait que la ligne à retard comporte huit éléments à retard (D1 .. D8) et que la sortie du deuxième élément à retard, la sortie du troisième élément à retard et la sortie du cinquième élément à retard sont reliées à d'autres entrées du détecteur de phase.

3.  Montage selon la revendication 2,

    caractérisé par le fait que le filtre passe-bas (TP) comporte une première et une seconde pompes de charge (CP1, CP2) qui sont capables d'alimenter un condensateur (C1), la première pompe de charge (CP1) étant reliée côté entrée, par l'intermédiaire d'un circuit d'évaluation (AL) du comparateur de phase (PD), à la sortie (Y2) du deuxième élément à retard (D2), à la sortie (Y3) du troisième élément à retard (D3) et à la sortie (Y5) du cinquième élément à retard (D5), alors que la seconde pompe de charge (CP2) est reliée côté entrée à la sortie (Y8) du huitième élément à retard (D8).

4.  Montage selon la revendication 3,

    caractérisé par le fait que la première pompe de charge (CP1) est capable de conduire un courant plus grand que la seconde pompe de charge (CP2).

FIG 1

FIG 2

FIG 3

# FIG 4

T

4T/5

4T/3

4T

Y0   Y1   Y2   Y3   Y4   Y5   Y6   Y7   Y8

# FIG 5

$I_{CP1}$ –
$I_{CP2}$ –

T

4T/3  3T/2        2T

0          T/2    4T/5

– $I_{CP2}$ –

– $I_{CP1}$ –